# EUROPEAN PATENT APPLICATION

(11) **EP 4 825 789 A1**
(43) Date of publication of application: **21.10.2026**
(21) Application number: 25170955.6
(22) Date of filing: 16.04.2025
(51) Int. Cl.: B81B 7/00, B81C 1/00

(54) **ELECTRONIC COMPONENT AND METHOD FOR THE MANUFACTURING THEREOF**

(71) Applicant: Murata Manufacturing Co., Ltd., Nagaokakyo-shi, Kyoto 617-8555 (JP)
(72) Inventor: PEUSSA, Marko, 02210 Espoo (FI); IIHOLA, Antti, 00950 Helsinki (FI); KILPINEN, Petteri, 02620 Espoo (FI)
(74) Representative: Boco IP Oy Ab

(57) **Abstract**

The invention discloses a microelectromechanical component and a method for manufacturing thereof. The component comprises a capping layer and a device layer which are bonded together. The capping layer comprises an insulating part. The insulating part comprises at least one silicon dioxide layer. The silicon dioxide layer is partly fabricated by thermal oxidation of the silicon semiconductor capping wafer.

## Description

### FIELD OF THE DISCLOSURE

This disclosure relates to microelectromechanical components and more particularly capping layers in such devices.

### BACKGROUND OF THE DISCLOSURE

Microelectromechanical systems (MEMS) are the technology of microscopic devices which combine mechanical and electrical features. MEMS devices can have either simple or complex structures with various moving parts. They include devices such as gyroscopes, acceleration sensors, magnetometers, and pressure sensors. MEMS devices may be fabricated from a silicon wafer by microfabrication techniques.

A MEMS component typically comprises a device layer and a capping layer, which work together to enable functionality, protection, and packaging. The device layer, which is usually made of silicon, contains the core mechanical and electrical elements, such as movable structures (e.g., beams, cantilevers, or moving mass elements) and electrodes, where sensing or actuation occurs. In contrast, the capping layer, often made of semiconductor part and insulating parts, is bonded to the device layer to protect the MEMS structures from environmental factors such as dust and moisture, provide mechanical support, create a controlled environment, such as vacuum or inert gas which are essential for proper operation, or create an electric contact to the outside. The bonding process, achieved through methods such as anodic bonding, fusion bonding (also known as direct bonding), or metallic bonding, ensures a secure and often hermetic seal. Glass is often used as the insulating part in the capping layer.

### BRIEF DESCRIPTION OF THE DISCLOSURE

The disclosed solution allows the use of a dielectric, and more particularly, silicon dioxide as the insulating part in a microelectromechanical component.

The object of the disclosure is achieved by a component and a manufacturing method which are characterized by what is stated in the independent claims. The preferred embodiments of the disclosure are disclosed in the dependent claims.

The disclosure is partly based on the idea of thermal oxidation of the silicon capping wafer to form a part of the insulating layer. The insulating layer is completed by adding a second insulating material. The manufacturing method enables the fabrication of a structure having small size conductive vertical feed-through vias surrounded by thick and wide insulating material. This allows a more stable component performance as parameter drifting are avoided, and an enhanced performance as the stray capacitance, along with undesirable noise are reduced.

### BRIEF DESCRIPTION OF THE DRAWINGS

In the following, the disclosure will be described in greater detail by means of preferred embodiments with reference to the accompanying drawings, in which
Figure 1a illustrates a microelectromechanical component comprising a capping layer, wherein the capping layer comprises a silicon dioxide insulating layer. In this example, the insulating layer fully surrounds the feed-through vias;
Figure 1b illustrates a microelectromechanical component comprising a capping layer, wherein the capping layer comprises a silicon dioxide insulating layer. In this example, the insulating layer surrounds only a portion of the feed-through vias;
Figure 2a illustrates a microelectromechanical component comprising a bottom metal electrode;
Figure 2b illustrates a microelectromechanical component comprising a bottom metal electrode and a top metal contact pad;
Figure 3a illustrates a microelectromechanical component comprising semiconductor mantles in accordance with one embodiment of this disclosure;
Figure 3b illustrates a microelectromechanical component comprising semiconductor mantles in accordance with another embodiment of this disclosure;
Figure 4a illustrates a microelectromechanical component in accordance with a further embodiment of the disclosure;
Figure 4b illustrates a schematic representation a cross-section in the xy-plane of the highlighted portion of the component shown in figure 4a. The figure shows a feed-through via and its surrounding;
Figure 5 illustrates a microelectromechanical component in accordance with a further embodiment of the disclosure;
Figure 6a-d illustrates an example method for the fabrication of the microelectromechanical component in accordance with one embodiment of this disclosure;
Figure 7a-i illustrates an example method for the fabrication of the microelectromechanical component in accordance with another embodiment of this disclosure.

### DETAILED DESCRIPTION OF THE DISCLOSURE

The disclosure describes a microelectromechanical component comprising a silicon capping layer, and a device layer. The capping layer and the device layer are bonded together. The capping layer has a top surface and a bottom surface, and the top surface of the capping layer defines a horizontal xy-plane and a vertical z-direction which is perpendicular to the xy-plane. The capping layer comprises an insulating part, and at least a portion of the insulating part extends in the z-direction from the top surface of the capping layer to the bottom surface of the capping layer.

The capping layer further comprises a feed-through via. The feed-through via extends in the z-direction in the capping layer. The insulating part comprises at least one silicon dioxide layer which surrounds at least a portion of the feed-through via and is in direct contact with the feed-through via.

A device layer refers to the part of the MEMS component which contains the functional microstructures, including moving mass elements, which enable the device to perform its intended function. The device layer may be formed using microfabrication techniques from a semiconductor wafer such as a silicon wafer.

Any direction or plane which is parallel to the xy-plane can be called horizontal. The direction which is perpendicular to the xy-plane can be called the vertical direction. Expressions such as "top", "bottom", "above", "below", "up" and "down" refer in this disclosure to differences in the vertical z-coordinate. These expressions do not refer to the orientation of the arrangement with regard to the direction of earth's gravitational field either when the arrangement is manufactured or when it is in use.

The thickness of the capping layer may be greater than 10 µm, preferably greater than 50 µm, and more preferably greater than 100 µm. The capping layer and the device layer may be bonded together by any method. For example, the capping layer may be bonded to the structure layer by anodic bonding, metal bonding or fusion bonding. These options may apply to any embodiment in this disclosure.

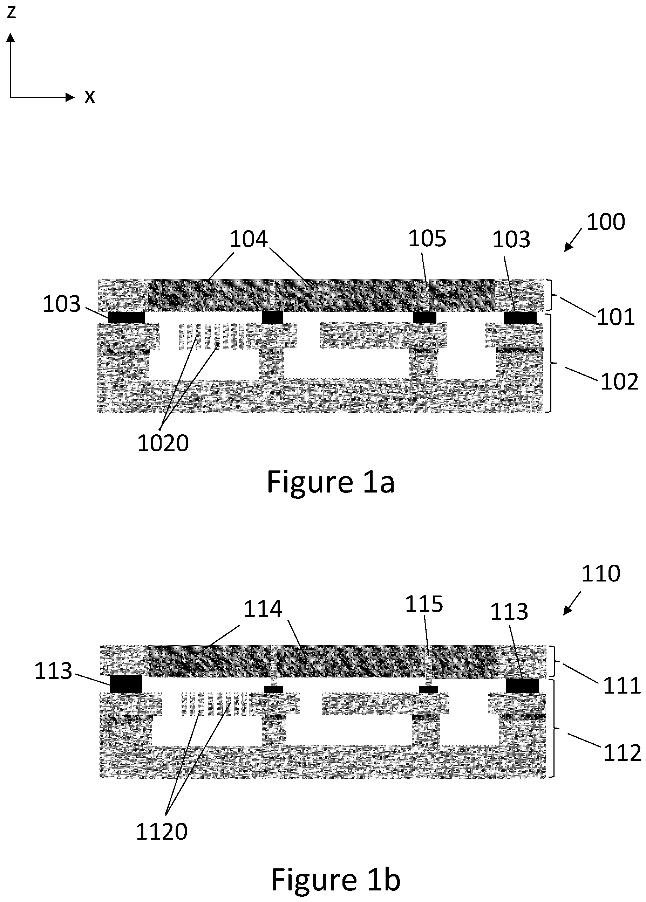

Figure 1a illustrates a microelectromechanical component in accordance with one embodiment of this disclosure. The component 100 comprises a capping layer 101 and a device layer 102 which are bonded to each other creating thereby a gap in which moving mass elements 1020 are suspended. In this example, the capping layer 101 is metal bonded to the device layer 102 through metal bonds 103. The capping layer comprises an insulating part 104 extending from the top surface to the bottom surface of the capping layer 101. The insulating part 104 comprises silicon dioxide (SiO₂). The capping layer 101 further comprises feed-through vias 105. In this example, the feed-through vias extend in the z-direction from the top surface of the capping layer 101 to the bottom surface of the capping layer 101 so that they are fully surrounded by the insulating part 104. In other words, the insulating part comprises at least one silicon dioxide layer which surrounds the entire lateral surface of feed-through via and is in direct contact with the feed-through via 105. The bottom end of the feed-through via 105 may be connected to the device layer 102 via a metal bond 103.

A feed-through via refers in this disclosure to a conductive channel extending from the top to the bottom of the capping layer 101 allowing electrical signals to pass from one side of the layer to the other. It may be made of the same material as the capping layer. For example, it may be made of single crystal silicon, or it may be made of polysilicon. Alternatively, it may be made of a metal such as Al, Cu, Ti, Mo or metal alloys such as TiW. The feed-through vias 105 may have various shapes including but not limited to cylindrical, tapered (conical), cubic or cuboid shape. These options may apply to any embodiment in this disclosure. A feed-through via may have a width, or a diameter, in the xy-plane in the range of 3 to 30 µm, and more preferably 5 to 15 µm. A feed-through via may have a length in the xy-plane in the range of 3 to 30 µm, and more preferably 5 to 15 µm. The options may apply to any embodiment in this disclosure.

Figure 1b illustrates a microelectromechanical component 110 in accordance with another embodiment of this disclosure. In this example, the feed-through vias 115 extend in the z-direction through the thickness of the capping layer 111 and protrude beyond the bottom surface of the capping layer 111 so that the insulating part 114 surrounds partly of the feed-through vias 115. In other words, the insulating part comprises at least one silicon dioxide layer which surrounds only a portion of the feed-through via and is in direct contact with the feed-through via 115. Reference numbers 112, 113, and 1120 in figure 1b correspond to reference numbers 102, 103, and 1020, respectively in figure 1a.

The microelectromechanical component may further comprise a bottom metal electrode. The expression "bottom metal electrode" refers in this disclosure to a metal electrode attached to the bottom surface of the capping layer. The bottom metal electrode may be attached to the insulating part and may extend horizontally so that it meets a feed-through via. Alternatively, the microelectromechanical component may further comprise a top metal contact pad or top metal routing attached to the top surface of the capping layer. The top metal contact pad or top metal routing may be attached to the insulating part and may extend horizontally so that it meets a feed-through via. The microelectromechanical component may comprise both a top metal contact pad or top metal routing and a bottom metal electrode. These options may apply to any embodiment in this disclosure.

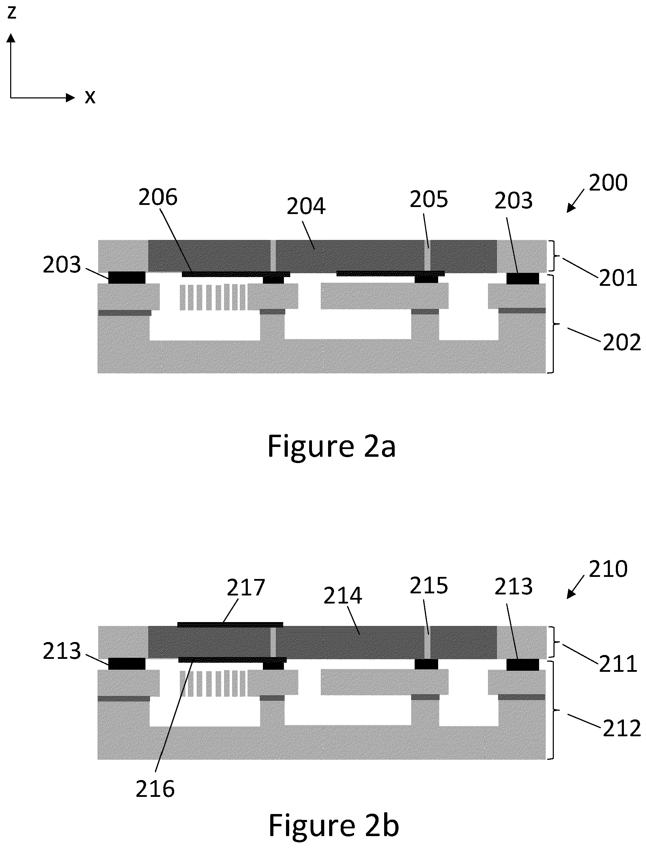

Figure 2a illustrates a microelectromechanical component according to a further embodiment of this disclosure. In this example, the microelectromechanical component 200 comprises a capping layer 201 and a device layer 202 which are bonded together. The capping layer 201 comprises a plurality of feed-through vias 205 extending in the z-direction from the top surface of the capping layer to the bottom surface of the capping layer. The capping layer 201 further comprises an insulating part 204 extending in the z-direction from the top surface of the capping layer to the bottom surface of the capping layer so that the insulating part fully surrounds each feed-through via 205. The insulating part 204 comprises at least one silicon dioxide layer. The component 200 further comprises a plurality of bottom metal electrodes 206. In this example, each bottom metal electrode 206 is attached to the bottom surface of the insulating part and extends in the xy-plane so that it meets the bottom surface of a feed-through via 205. Reference number 203 in figure 2a corresponds to reference number 103 in figure 1a.

Figure 2b illustrates a microelectromechanical component according to a further embodiment of this disclosure. The capping layer 211 comprises a plurality of feed-through vias 215 and an insulating part 214 extending in the z-direction from the top surface of the capping layer to the bottom surface of the capping layer, so that the insulating part 214 fully surrounds each feed-through via 215. The insulating part 214 comprises at least one silicon dioxide layer. In this example, the component 210 comprises a bottom metal electrode 216 and a top metal contact pad or top metal routing 217. The bottom metal electrode 216 is attached to the bottom surface of the insulating part and extends in the xy-plane so that it meets the bottom surface of a feed-through via 215, and the top metal contact pad or top metal routing 217 is attached to the top surface of the insulating part and extends in the xy-plane so that it meets the top surface of a feed-through via 215. In other words, the insulating silicon dioxide layer extends in the z-direction between the top metal contact pad or top metal routing 217 and the bottom metal electrode 2016. Normally, the large 3D-surface area of bulk silicon parts is a source of high stray capacitance in both the horizontal and vertical directions. Because bulk silicon parts are reduced and the size of the feed-through via is smaller (its surface area is also smaller) signal coupling from the feed-through surface to the surrounding silicon parts (neighbouring feed-through vias or bulk silicon parts) decreases, particularly in the horizontal direction. This leads to an improvement of the stray capacitance, and therefore the improvement of the component's performance. Another advantage is that more stable element performance is achieved by replacing the conventionally used glass insulating part with the dielectric structure presented in the present disclosure because when glass is used as the insulating part in the capping layer, the mobile alkaline ions in the glass matrix typically generate parameter drifting over time and temperature. Reference numbers 212 and 213 in figure 2b correspond to reference numbers 102 and 103, respectively, in figure 1a.

The capping layer may further comprise one or more silicon mantles. The one or more silicon mantles may extend in the z-direction from the top surface of the capping layer through a portion of the thickness of the insulating part. The expression "mantle" refers in this invention to a three-dimensional semiconductor portion (silicon portion) of the capping layer, which is fully or partially enclosed within the insulating part. In other words, the silicon mantle is either fully surrounded by the insulating part, or the top surface of the silicon mantle is not covered by the insulating part. For example, the top surface of the silicon mantle may be a surface which is covered by a top metal contact pad or top metal routing. The one or more silicon mantles may be distant from or adjacent to the feed-through vias. Alternatively, the one or more silicon mantles may extend in the x-direction so that they are in contact with a feed-through via. The silicon mantles may have various dimensions and shapes. For example, they may be cylindrical, conical, cubic or cuboid shape, etc. These options may apply to any embodiment in this disclosure. Silicon mantles provide good adhesion to the top metal contact pads or top metal routings. Additionally, they may also be a pathway allowing electrical signals to be transported through the component and/or may improve the mechanical properties of the capping layer by improving the coefficient of thermal expansion of the capping layer and giving mechanical support to the feed-through vias.

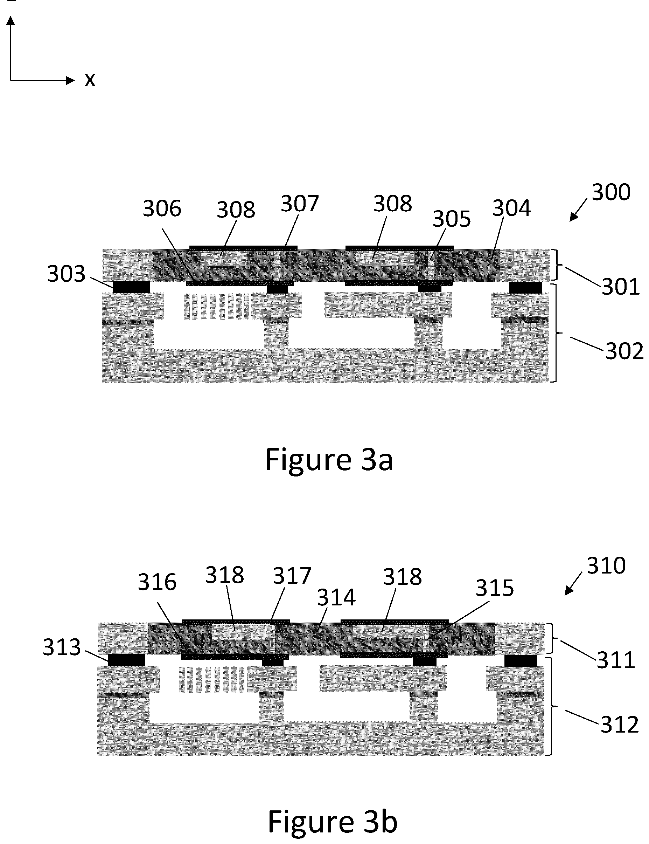

Figure 3a illustrates a microelectromechanical component 300 comprising semiconductor mantles in accordance with one embodiment of this disclosure. In this example, the microelectromechanical component 300 comprises top metal contact pads or top metal routings 307 located on the top surface of the capping layer 301, and the capping layer 301 comprises a plurality of silicon mantles 308 extending in the z-direction from the top metal contact pads or top metal routings 307 through a portion of the thickness of the insulating part 304. Each silicon mantle 308 is adjacent to a feed-through via 305. Reference numbers 302, 303, and 306 in figure 3a correspond to reference numbers 202, 203, and 206, respectively, in figure 2a.

Figure 3b illustrates a microelectromechanical component 310 comprising semiconductor mantles in accordance with another embodiment of this disclosure. In this example, the capping layer 311 comprises a plurality of silicon mantles 318 which extend in the z-direction from the top metal contact pads or top metal routings 317 through a portion of the thickness of the insulating part 314. Each silicon mantle 318 further extends in the x-direction so that it is in contact with a feed-through via 315. In this example, each silicon mantle 318 forms, together with its neighbouring feed-through vias, a pathway allowing electrical signals to be transported from the top metal contact pads or top metal routings 317 to the bottom metal electrodes 316, and therefore to the device layer 312. Reference number 313 figure 3b corresponds to reference number 203 in figure 2a.

The insulating part may comprise a plurality of silicon dioxide layers and a plurality of dielectric layers. The silicon dioxide and the dielectric layers may be arranged repetitively and alternatively around the feed-through via so that they form a coaxial Layered structure. The dielectric layers may either be high-k or low-k dielectric layers. The dielectric layers may comprise silicon nitride such as SiN₄ or SiNₓ or may comprise aluminium nitride (AlN). Alternatively, the dielectric layers may comprise silicon dioxide. These options may apply to any embodiment in this disclosure.

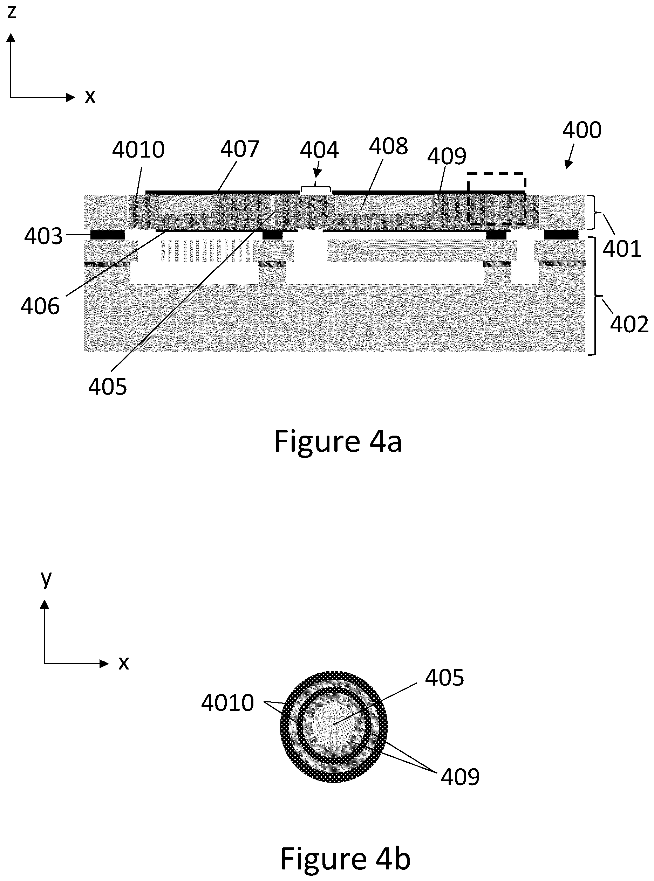

Figure 4a illustrates a microelectromechanical component in accordance with a further embodiment of the disclosure. The microelectromechanical component 400 comprises a silicon capping layer 401, and a silicon device layer 402. In this example, the capping layer 401 and the device layer 402 are metal bonded together via metal bonds 403. The capping layer comprises an insulating part 404, and a portion of the insulating part extends in the z-direction from the top surface of the capping layer 401 to the bottom surface of the capping layer. The capping layer 401 further comprises a plurality of feed-through vias 405, and a plurality of silicon mantles 408. The feed-trough vias 405 and the silicon mantles 408 are next to each other.

The microelectromechanical component 400 further comprises a plurality of top metal contact pads or top metal routings 407 and a plurality of bottom metal electrodes 406. In this example, each top metal contact pad or top metal routing 407 extends in the x-direction so that it covers a silicon mantle 408, its neighbouring feed-through via 405, and the portion of the insulating part 404 which lies between the silicon mantle 408 and its neighbouring feed-through via 405. Each feed-through via 405 extends from a top metal contact pad or top metal routing 407 to a bottom metal electrode 406. In this example, the insulating part 404 comprises a plurality of silicon dioxide layers 409 and a plurality of dielectric layers 4010.

Figure 4b illustrates a schematic representation a cross-section in the xy-plane of the highlighted potion of the component shown in figure 4a. The figure shows a feed-through via 405 and its surrounding. The silicon dioxide layers 409 and the dielectric layers 4010 are arranged repetitively and alternatively around the feed-through via 405 so that they form a coaxial Layered structure, and one silicon dioxide layer 409 is in direct contact with the feed-through via 405.

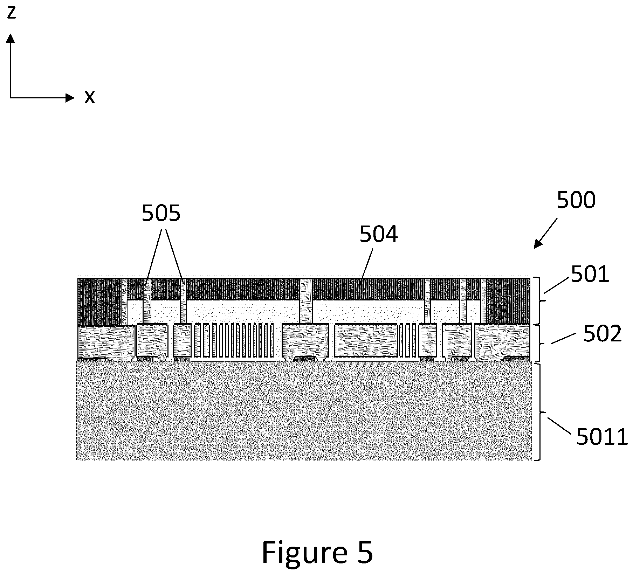

The microelectromechanical component 500 may further comprise an additional semiconductor layer as shown in figure 5. The additional semiconductor layer 5011 may be attached to the device layer 502. The additional semiconductor layer 5011 may for example be an ASIC die. These options may apply to any embodiment in this disclosure. Reference numbers 501, 504, and 505 in figure 5 correspond to reference numbers 111, 114, and 115, respectively, in figure 1b.

The disclosure further describes a method for manufacturing a microelectromechanical component. The method comprises providing a silicon wafer. The wafer defines a horizontal xy-plane and a vertical z-direction which is perpendicular to the xy-plane. The wafer has a top surface and a bottom surface. The wafer further comprises a feed-through region and a capping region. The feed-through region is adjacent to the capping region. The method further comprises: (1) forming a first set of trenches and silicon structures in the capping region, so that the trenches in the first set trenches are separated from each other by the silicon structures. Each structure has a length and a width in the xy-plane and the length is greater than the width. The trenches in the first set of trenches extend in the z-direction from the top surface of the wafer through a portion of the thickness of the wafer, (2) forming at least one additional trench and at least one silicon feed-through island in the feed-through region. The at least one additional trench surrounds the at least one feed-through island. The at least one additional trench extends in the z-direction from the top surface of the wafer through a portion of the thickness of the wafer. The at least one feed-through island has a width and a length in the xy-plane, and the width and the length of the at least one feed-through island are greater than the width of the silicon structures, (3) thermally oxidizing the wafer so that the silicon structures are fully converted into silicon dioxide structures and a portion the at least one feed-through island is converted into silicon dioxide, (4) forming a dielectric layer on the top surface of the wafer, so that the dielectric layer fully fills the first set of trenches, and the at least one additional trench.

The disclosure further discloses a microelectromechanical component in accordance with the above manufacturing method.

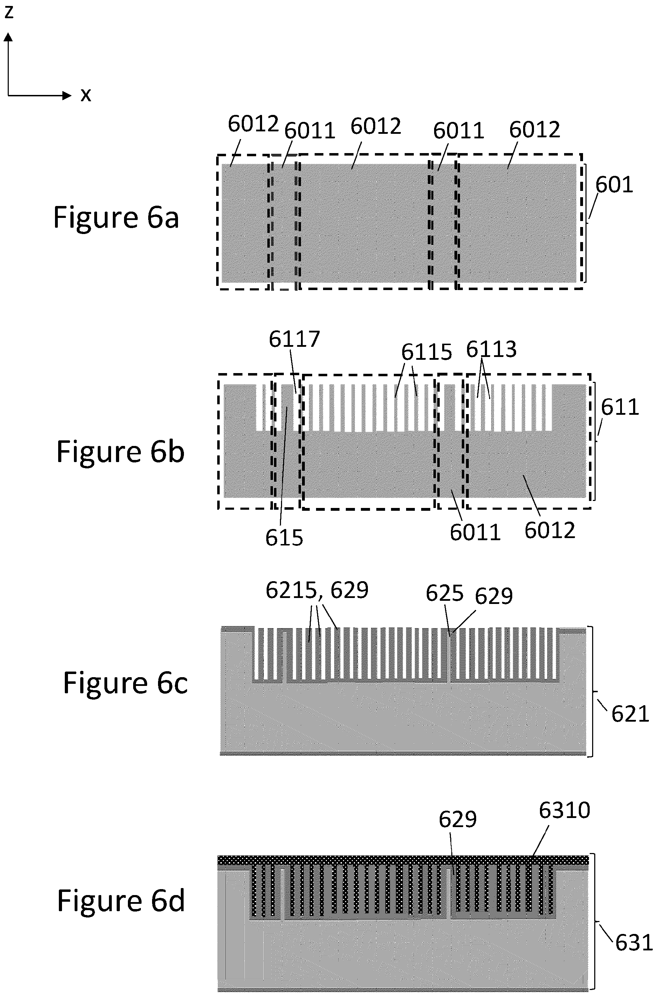

Figure 6a-d illustrates an example method for the fabrication of the microelectromechanical component in accordance with one embodiment of this disclosure.

Figure 6a illustrates the first step of the method. The step comprises providing a silicon wafer 601. The wafer defines a horizontal xy-plane and a vertical z-direction which is perpendicular to the xy-plane. The wafer has a top surface and a bottom surface. The wafer comprises a feed-through region 6011 and a capping region 6012. The feed-through region 6011 is adjacent to the capping region 6012.

Figure 6b illustrates further steps of the method. One of these steps comprises forming a first set of trenches 6113 and silicon structures 6115 in the capping region, so that the trenches in the first set trenches 6113 are separated from each other by the silicon structures 6115. The trenches in the first set of trenches extend in the z-direction from the top surface of the wafer through a portion of the thickness of the wafer 611.

The method further comprises forming at least one additional trench and at least one silicon feed-through island in the feed-through region 6011. The at least one additional trench and the at least one silicon feed-through island may be formed at the same time as the first set of trenches 6113 and silicon structures 6115. In this example two additional trenches 6117 and two feed-through islands 615 are formed in the feed-through region 6011. Each additional trench 6117 surrounds a feed-through island 615. The additional trenches extend in the z-direction from the top surface of the wafer through a portion of the thickness of the wafer 611.

Figure 6c illustrates a further step of the method. This step comprises thermally oxidizing the wafer 621 so that the silicon structures 6115 are fully converted into silicon dioxide structures 6215 and a portion of each feed-through island 625 is converted into silicon dioxide 629.

Figure 6d illustrates the step of forming a dielectric layer 6310 on the top surface of the wafer 631 so that the dielectric layer 6310 fully fills the first set of trenches 6113 and the additional trenches 6117. The dielectric layer may either be high-k or low-k dielectric layers. The dielectric layer may comprise silicon nitride such as Si₃N₄ or SiNₓ, or aluminium nitride (AlN). Alternatively, the dielectric layer may comprise silicon dioxide. This additional silicon dioxide layer may be formed by plasma enhanced chemical vapor deposition (PECVD). For example, it may be a PECVD SiO₂ formed using silane as precursor or a TEOS PECVD SiO₂ formed using tetraethyl orthosilicate as precursor. Alternatively, the additional silicon dioxide layer may be formed by other methods such as atomic layer deposition (ALD). These options may apply to any embodiment in this disclosure. When the dielectric layer comprises a second silicon dioxide layer, the method may further comprise the step of annealing the wafer after forming the dielectric layer so that the silicon dioxide structures and the dielectric layer merge forming a single silicon dioxide layer.

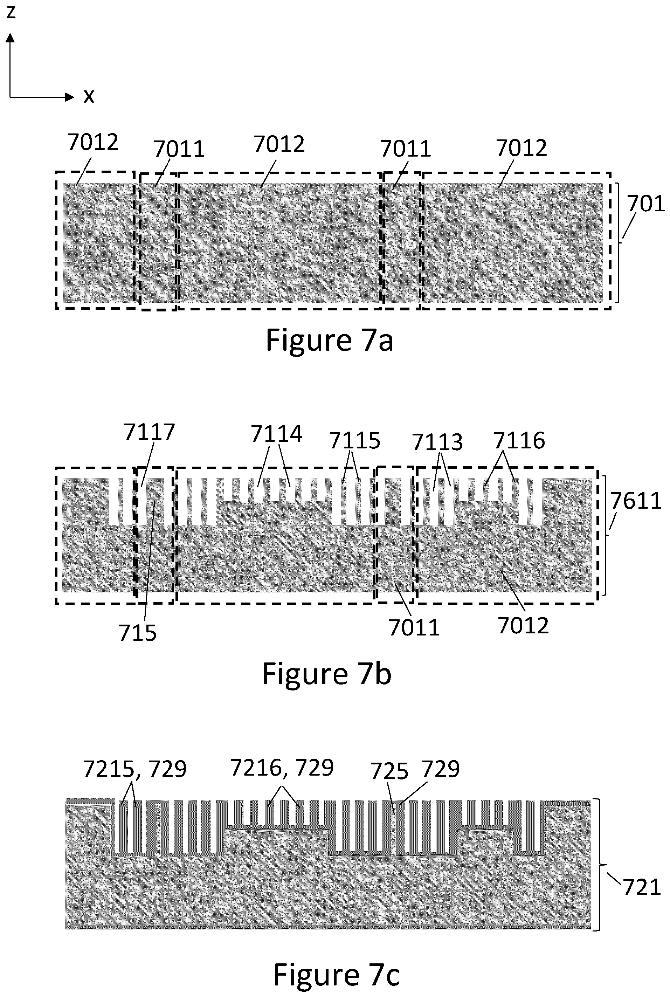

Figure 7a-i illustrates an example method for the fabrication of the microelectromechanical component in accordance with another embodiment of this disclosure.

Figure 7a illustrates the first step of the method. The step comprises providing a silicon wafer 701. The wafer comprises a feed-through region 7011 and a capping region 7012. The feed-through region 7011 is adjacent to the capping region 7012.

The method may further comprise forming a second set of trenches and additional silicon structures in the capping region, so that the trenches in the second set of trenches are separated from each other by the additional silicon structures. The width and the length of the at least one feed-through island are greater than the width of the additional silicon structures. The trenches in the first set of trenches may extend in the z-direction from the top surface of the wafer through a portion of the thickness of the wafer by a first depth, and the trenches in the second set of trenches may extend in the z-direction from the top surface of the wafer through a portion of the thickness of the wafer by a second depth. The first depth is greater than the second depth.

Figure 7b illustrates further steps of the method. In this example, the method comprises forming a first set of trenches 7113, a second set of trenches 7114, silicon structures 7115 and additional silicon structures 7116 in the capping region so that the trenches in the first set of trenches are separated by the silicon structures 7115 and the trenches in the second set of trenches are separated by the additional silicon structures 7116. Each silicon structure 7115 and additional silicon structure 7116 has a length and a width in the xy-plane, and the length is greater than the width. The trenches in the first set of trenches extend in the z-direction from the top surface of the wafer through a portion of the thickness of the wafer by a first depth, and the trenches in the second set of trenches extend in the z-direction from the top surface of the wafer through a portion of the thickness of the wafer by a second depth. The first depth is greater than the second depth. The trenches in the first set of trenches and the trenches in the second set of trenches may be formed by methods such as deep reactive ion etching (DRIE), conventional reactive ion etching (RIE), inductively coupled plasma (ICP) etching, or wet etching methods. These options may apply to any embodiment in this disclosure.

Another step in this example comprises forming two additional trenches 7117 and two feed-through islands 715 in the feed-through region 7011. Each additional trench 7117 extends in the z-direction from the top surface of the wafer 711 through a portion of the thickness of the wafer 711 and surrounds a silicon feed-through island 715. The feed-through islands 715 have a width and a length in the xy-plane. The width and the length of the feed-through islands 715 are greater than the width of the silicon structures 7115 and the width of the additional silicon structures 7116.

Figure 7c illustrates a further step of the method. This step comprises thermally oxidizing the wafer 721 so that the silicon structures 7115 are fully converted into silicon dioxide structures 7215, the additional silicon structures 7116 are fully converted into additional silicon dioxide structures 7216, and a portion of each feed-through island 725 is converted into silicon dioxide 729.

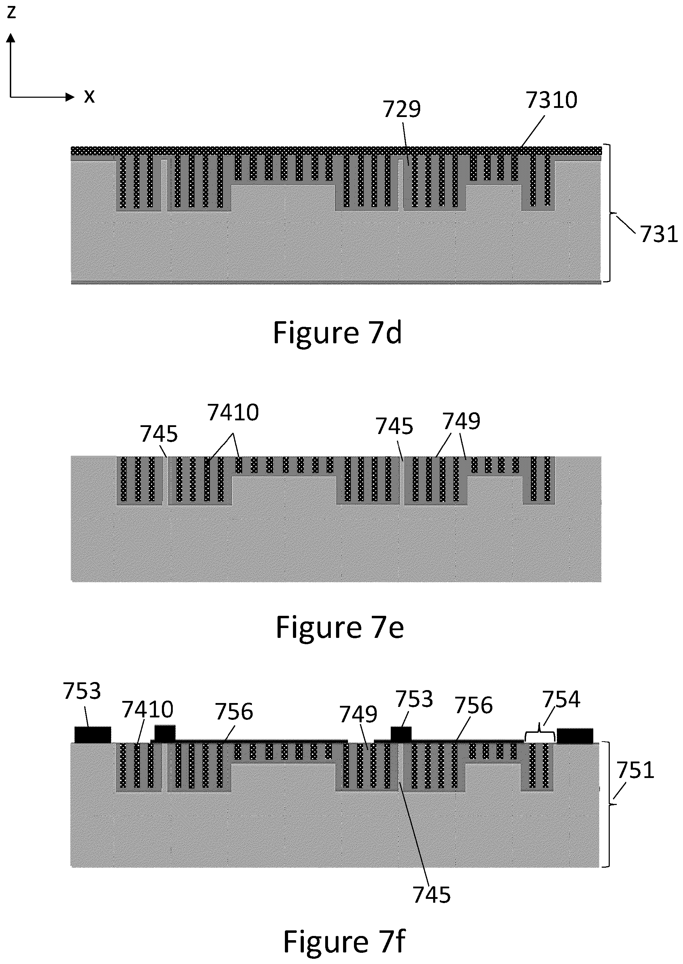

Figure 7d illustrates the step of forming a dielectric layer 7310 on the top surface of the wafer 731 so that the dielectric layer 7310 fully fills the first set of trenches 7113, the second set of trenches 7114, and the additional trenches 7117.

The method may further comprise after forming the dielectric layer, removing a portion of the dielectric layer and the silicon dioxide so that the oxide-free top surface of the at least one feed-through island is exposed.

Figure 7e illustrates a possible additional step in the method. In this example, the method further comprises removing the top portion of the dielectric layer 7310 and the top portion of the silicon dioxide layer 729 so that the oxide-free top surface of the feed-through island 745 is exposed. This step may result in an insulating layer arrangement comprising multiple silicon dioxide layers 749 and multiple dielectric layers 7410, where the silicon dioxide and the dielectric layers are positioned repetitively and alternatively around the feed-through islands 745 so that they form coaxial Layered structures. This step may also result in the insulating layer having multiple silicon dioxide layers and dielectric layers positioned repetitively and alternatively along the x-direction in the capping region.

Figure 7f illustrates possible additional steps in this example method. One of these steps may comprise the formation of a first metal electrode 756 on top of one feed-through island 745. The metal electrode 756 may extend in the x-direction from the top surface of the feed-through island 745 along a portion of the capping region so that it covers a portion of the top surface of the insulating layer 754 which comprises at this stage multiple silicon dioxide layers 749 and multiple dielectric layers 7410. Another step may comprise the formation of metal bonds 753 on the edges of the silicon wafer 751 and optionally on the metal electrode 756 in the feed-through region.

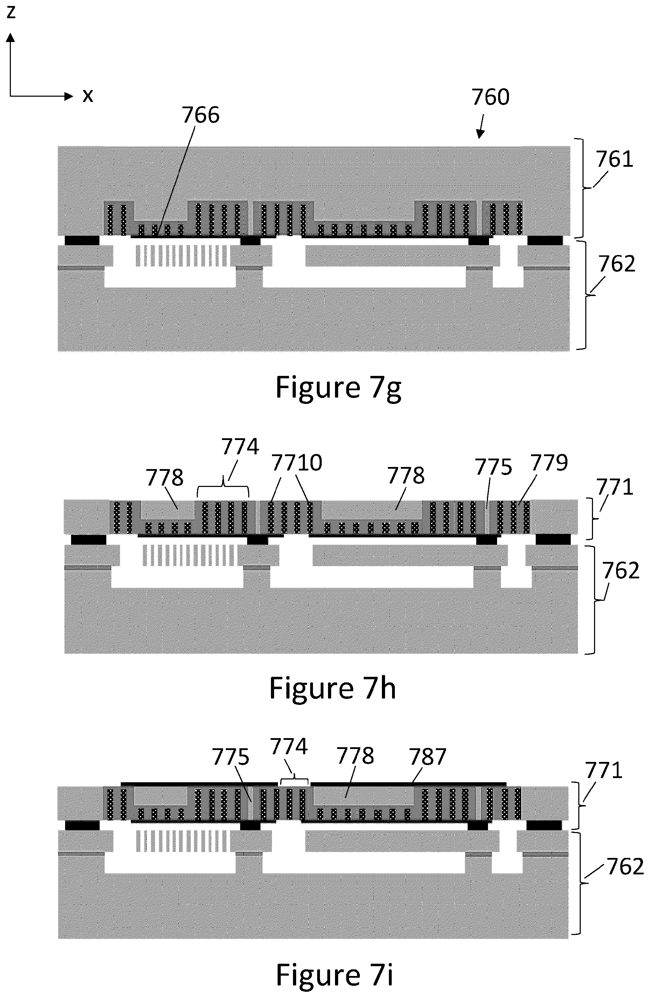

Figure 7g illustrates a possible additional step in the manufacturing method. This step comprises metal bonding the silicon wafer 761 to a device layer 762 forming thereby a microelectromechanical component 760, where the silicon wafer acts as the capping layer in the component. Alternatively, the silicon wafer may be anodically, or fusion bonded to the device layer. These options may apply to any embodiment in this disclosure. The capping layer is positioned on top of the device layer so that metal electrode 766 faces the device layer 762, thereby becoming the bottom metal electrode in the component 760. The thickness of the silicon wafer may be greater than 10 µm, preferably greater than 50 µm, and more preferably greater than 100 µm. These options may apply to any embodiment in this disclosure.

The method may further comprise removing at least a portion of the silicon wafer so that at least a portion of the silicon dioxide and the dielectric layer extend from the top surface of the wafer to the bottom surface of the wafer in the capping region, and at least one silicon feed-through via is formed in the feed-through region.

Figure 7h illustrates a further possible step of the method. In this example, this step comprises removing the top part of the capping layer 761 so that at least a portion of the silicon dioxide 779 and the dielectric layer 7710 extend from the top surface to the bottom surface of the capping layer 771 in the capping region, and silicon feed-through vias 775 are formed in the feed-through region. In this example, this step also results in the formation of several silicon mantles 778. The silicon mantles 778 extend in the z-direction from the top surface of the capping layer 771 through a portion of the thickness of the insulating part 774. The silicon mantles 778 may be distant from or adjacent to feed-through vias. Alternatively, a silicon mantle may extend in the x-direction so that it meets a feed-through via. The silicon mantles may have various dimensions and shapes. For example, they may be cylindrical, conical, cubic or cuboid shape, etc. These options may apply to any embodiment in this disclosure. In this example, the silicon mantles 778 have cuboid shapes.

Figure 7i illustrates a further possible step of the method. This step may comprise the formation of one or more top metal contact pads or top metal routings 787 on the top surface of the cap wafer 771. In other words, the one or more top metal contact pads or top metal routing 787 may be formed on top of silicon mantles 778 and a portion of the top surface of the insulating part 774. A top metal contact pad or top metal routing 787 may extend horizontally from a silicon mantle 778 along the potion of the insulating part that it covers so that it is in contact with a feed-through via 775.

## Claims

1. A microelectromechanical component comprising a silicon capping layer, and a device layer wherein the capping layer and the device layer are bonded together, and wherein the capping layer has a top surface and a bottom surface, and the top surface of the capping layer defines a horizontal xy-plane and a vertical z-direction which is perpendicular to the xy-plane,
and wherein the capping layer comprises an insulating part, and at least a portion of the insulating part extends in the z-direction from the top surface of the capping layer to the bottom surface of the capping layer,
and wherein the capping layer further comprises a feed-through via, wherein the feed-through via extends in the z-direction in the capping layer,
**Characterized in that**
the insulating part comprises at least one silicon dioxide layer which surrounds at least a portion of the feed-through via and is in direct contact with the feed-through via.

2. A microelectromechanical component according to claim 1, wherein the insulating part comprises a plurality of silicon dioxide layers and a plurality of dielectric layers, and wherein the silicon dioxide and the dielectric layers are arranged repetitively and alternatively around the feed-through via so that they form a coaxial Layered structure.

3. A microelectromechanical component according to claim 2, wherein the dielectric layers comprise a silicon nitride.

4. A microelectromechanical component according to claim 2, wherein the dielectric layers comprise silicon dioxide.

5. A microelectromechanical component according to any of claims 1-4, wherein the capping layer further comprises one or more silicon mantles, wherein the one or more silicon mantles extend in the z-direction from the top surface of the capping layer through a portion of the thickness of the insulating part.

6. A microelectromechanical component according to any of claims 1-5, wherein the thickness of the capping layer is greater than 10 µm, preferably greater than 50 µm, and more preferably greater than 100 µm.

7. A method for manufacturing a microelectromechanical component, wherein the method comprises:
- Providing a silicon wafer, wherein the wafer defines a horizontal xy-plane and a vertical z-direction which is perpendicular to the xy-plane, and the wafer has a top surface and a bottom surface, and wherein the wafer comprises a feed-through region and a capping region, and wherein the feed-through region is adjacent to the capping region,
**Characterized in that** the method further comprises:
- Forming a first set of trenches and silicon structures in the capping region, so that the trenches in the first set trenches are separated from each other by the silicon structures, wherein each structure has a length and a width in the xy-plane, and the length is greater than the width, and wherein the trenches in the first set of trenches extend in the z-direction from the top surface of the wafer through a portion of the thickness of the wafer,
- Forming at least one additional trench and at least one silicon feed-through island in the feed-through region, wherein the at least one additional trench surrounds the at least one feed-through island, and the at least one additional trench extends in the z-direction from the top surface of the wafer through a portion of the thickness of the wafer, and wherein the at least one feed-through island has a width and a length in the xy-plane, and wherein the width and the length of the at least one feed-through island are greater than the width of the silicon structures,
- Thermally oxidizing the wafer, so that the silicon structures are fully converted into silicon dioxide structures, and a portion of the at least one feed-through island is converted into silicon dioxide,
- Forming a dielectric layer on the top surface of the wafer, so that the dielectric layer fully fills the first set of trenches, and the at least one additional trench.

8. A method according to claim 7, wherein the method further comprises forming a second set of trenches and additional silicon structures in the capping region, so that the trenches in the second set of trenches are separated from each other by the additional silicon structures, and wherein the width and the length of the at least one feed-through island are greater than the width of the additional silicon structures, and wherein the trenches in the first set of trenches extend in the z-direction from the top surface of the wafer through a portion of the thickness of the wafer by a first depth, and the trenches in the second set of trenches extend in the z-direction from the top surface of the wafer through a portion of the thickness of the wafer by a second depth, and wherein the first depth is greater than the second depth.

9. A method according to any of claims 7-8, wherein the method further comprises after forming the dielectric layer, removing a portion of the dielectric layer and the silicon dioxide so that the oxide-free top surface of the at least one feed-through island is exposed.

10. A method according to claim 9, wherein the method further comprises removing at least a portion of the silicon wafer so that at least a portion of the silicon dioxide and the dielectric layer extend from the top surface of the wafer to the bottom surface of the wafer in the capping region, and at least one silicon feed-through via is formed in the feed-through region.

11. A method according to any of claims 7-10, wherein the thickness of the silicon wafer is greater than 10 µm, preferably greater than 50 µm, and more preferably greater than 100 µm.

12. A method according to any of claims 7-11, wherein the dielectric layer comprises silicon nitride.

13. A method according to any of claims 7-11, wherein the dielectric layer comprises silicon dioxide.

14. A method according to claim 13, wherein the method further comprises annealing the wafer after forming the dielectric layer so that the silicon dioxide structures and the dielectric layer merge forming a single silicon dioxide layer.
